# EUROPEAN PATENT SPECIFICATION

(11) **EP 0 422 919 B1**
(45) Date of publication and mention of the grant of the patent: **01.02.1995**
(21) Application number: 90311106.0
(22) Date of filing: 10.10.1990
(51) Int. Cl.: C09J 7/02

(54) **Antistatic adhesive tape**
Antistatisches Klebeband
Ruban adhésif antistatique

(30) Priority: 11.10.1989 IE 327889
(43) Date of publication of application: 17.04.1991
(73) Proprietor: WATERFORD RESEARCH & DEVELOPMENT LIMITED, Waterford (IE)
(72) Inventor: Weinhold, Lutz R., Fenor-Tramore, Co. Waterford (IE); McDonough, John D., Dunmore Road, Waterford (IE)
(74) Representative: Parkes, Andrew John Aykroyd

(56) References cited:
- EP-A- 0 330 452
- DE-A- 1 594 137
- US-A- 4 548 862
- PATENT ABSTRACTS OF JAPAN, vol. 12, no. 213 (C-505)(3060), 17 June 1988; & JP-A-63 012 681

## Description

This invention relates to antistatic pressure-sensitive adhesive tapes for use in high temperature operations at up to 250°C, particularly for use in masking selected areas of electronic components such as printed circuit boards during high temperature operations such as soldering in electronic assembly processes.

During the electronic assembly process, the many components that go into making an electronic circuit are assembled together and installed in a printed circuit board which is subsequently processed in a soldering operation. In recent years electronic devices have increasingly been getting more complex and miniaturisation has resulted in the production of very dense, low power consuming devices. These devices are prone to damage by electrostatic discharge (ESD). For example M.O.S. (metal oxide silicon) devices, which are widely used today, may contain gates which are constructed of aluminium insulated by aluminium oxide. These traces are of the order of 1-2 micrometres wide. Electrostatic discharge can damage the insulating trace, causing a permanent electrical short which may occur at the time of the discharge or perhaps only when the device has been in use for a period of time. This can be very expensive to rectify. In areas where these devices are assembled, it is usual practice to eliminate all sources of static electricity by means of earthing all furniture, equipment and personnel and by using conductive materials in the surroundings as much as possible. Any static discharge in the order of 10-50 volts can damage MOS type devices.

During the wave soldering process, where the assembled components are soldered onto a printed circuit board, it is very often necessary to mask areas of the board, such as gold fingers and certain through-holes, from the solder wave.

It is well known to achieve masking during wave soldering by use of self-adhesive tapes based on high-temperature-resistant polyimide film with a silicone-based adhesive. However the removal of such tapes after use involves peeling them away by breaking the adhesive bond between the adhesive and the electronic component. Due to the insulative nature of the film and adhesive, this results in creation of a static charge which can be damaging to a sensitive electronic component. Furthermore such tapes before use are normally stored in rolls, and the unwinding of the tape from the roll also creates static in the environment, which could damage static-sensitive devices.

Antistatic adhesive tapes are known for other working environments and uses. U.S. Patents 3,104,985, 3,832,598 and 4,749,612 describe adhesive tapes in which carbon black in a binder is used as a coating on the front face of a tape for the purpose of dissipating electrostatic charges. Japanese Patent Publication No. J 63,012,681-A (Application No. 86 JP-155,278) describes a tape or sheet comprising an antistatic layer (e.g. cationic acrylic polymer) formed in an intermediate layer interposed between the support (e.g. polypropylene) and the adhesive layer (e.g. rubber) and also comprises an intermediate support lying between the antistatic layer and the adhesive layer. Japanese Patent Publication No. J 61,272,279-A (Application No. 85 JP-116,029) describes an antistatic adhesive tape or sheet having an electrically insulating support material with an antistatic layer with "a surface resistance of 10¹¹ ohm/sq. or less" formed by coating the support material with ion conductive polymers. The adhesive layer is formed on the antistatic layer.

None of these proposed tapes would have the high-temperature resistance required for a tape in the electronics industry. Furthermore, a surface electrical resistance not greater than 10⁷ohms/cm is desirable for dissipating electrostatic discharge.

Films filled with carbon are also known, but the use of such films for the support of an adhesive tape would involve significant expense and a risk of reduction in the physical characteristics which are required in the support film.

Conductive adhesives are also known for other purposes. Canadian Patent No. 1,237,176 Hartman describes a pressure-sensitive adhesive tape, a layer of which contains electrically conductive particles affording conductive paths through the thickness of the layer for making electrical connections, such as between two arrays of electrical terminals in an electronic device. Optionally, the carrier web of the tape may carry either a coextensive, electrically conductive layer or a plurality of spaced electrically conductive strips such as copper foil. U.S. Patent 3,475,213 (Stow) discloses a tape having an electrically conductive backing and a pressure sensitive adhesive layer which contains a monolayer of electrically conductive particles whose thickness approximates the thickness of the adhesive layer. However these tapes are not designed for dissipation of static and they do not have the high-temperature resistance required in a masking tape for use during wave soldering and similar high temperature operations.

Two types of tape are known for electromagnetic shielding to prevent interference, e.g. in sealing computer cabinets. One of these types of tape comprises a conductive metal foil and a layer of pressure-sensitive adhesive filled with electrically conductive particles which provide conductive pathways through the thickness of the adhesive layer. The other of these types of tape comprises a conductive metal foil and a non-conductive pressure-sensitive adhesive, in which the metal foil has been embossed to form protrusions which extend through the thickness of the adhesive layer to provide electrical contact points at the outer surface of the adhesive layer. The embossed type of tape is made by applying the adhesive to a plane metal foil e.g. of aluminium or copper and then embossing the foil so that a pattern of protrusions is pushed through the adhesive at various points. However both of these types of tape, being for sealing purposes, are not required to be stripped away after use, nor are they required to withstand high temperature operations.

It is an object of the present invention to provide a pressure-sensitive adhesive tape which combines high-temperature resistance with a high ability to dissipate static. Although the tape is specifically described for use as a masking tape in the electronics industry, it has utility also in other industries and environments where this combination of properties is advantageous.

The present invention provides an antistatic pressure-sensitive adhesive tape comprising:
1) a polymeric film support;
2) an intermediate electrically-conductive layer;
   and
3) a layer of pressure-sensitive adhesive;
wherein electrically conductive pathways are provided from the outer surface of the pressure-sensitive adhesive layer to the intermediate layer,
and wherein the polymeric film support, intermediate layer and pressure-sensitive adhesive layer are all resistant to temperatures up to 250°C for up to 5 seconds.

The term "tape" as used in this Specification covers not only a continuous tape (i.e. in strip form) but also shaped pieces of tape. Preferably the film support, intermediate layer and adhesive layer are all resistant to temperatures up to 260°C for up to 25 seconds.

The elements 1), 2) and 3) are present in the tape in this order i.e. the intermediate layer 2) lies between the support 1) and the adhesive layer 3). Normally the intermediate layer 2) is on the support 1) and the adhesive layer 3) is on the intermediate layer.

In order to satisfy the requirement of resistance to high temperature, the tape must maintain its physical dimensions during treatment at the designated temperatures and times, without significant shrinkage or deformation, and without significant loss of cohesive or adhesive properties.

The tape according to the invention is advantageous because it can be unwound from a roll without static discharge to the surroundings, it can be used for masking or other purposes during high-temperature operations and it can be stripped from the workpiece after use without static discharge to the surroundings. The structure of the tape provides conductive pathways for dissipating static generated when the adhesive is removed from a surface to which it is bonded.

The intermediate layer preferably comprises a layer of a polymeric binder containing electrically conductive particles which provide conductive pathways in at least one direction parallel to the main plane of the tape. Alternatively the intermediate coating may comprise a metal coating (e.g. of Aluminium) applied to the polymeric film support, e.g. the support and the coating may be prepared as a metallised polymeric film; or the coating may comprise a conductive foil laminated to the support.

Preferably the adhesive layer 3) is in contact with the intermediate layer 2) and the adhesive contains electrically conductive particles which provide conductive pathways from one main face of the adhesive layer to the other.

Preferably the intermediate layer 2) has a surface electrical resistance at ambient temperature not greater than about 10⁷ ohms/cm, more preferably not greater than about 10⁵ ohms/cm.

Likewise the outer surface of the adhesive layer 3) of the tape preferably has a bridging resistance at ambient temperature between two points thereon (but taking account of the path of the electrical current through both the adhesive layer and the intermediate layer) not greater than about 10⁷ ohms/cm, more preferably not greater than about 10⁵ ohms/cm.

Binders used in the intermediate coating and the adhesive layer should be compatible in so far as interadhesion between the layers is concerned so as to avoid delamination of the tape, particularly during stripping away of the tape after heat treatment.

In an alternative embodiment, the intermediate electrically conductive layer has protrusions which extend through the adhesive layer 3) and which provide the electrically conductive pathways from the outer surface of the adhesive layer to the intermediate layer. More particularly, the intermediate layer may comprise a metal foil which has been embossed to produce such protrusions. The metal foil should be a non-solderable metal because the metal may be exposed to solder at an edge of the tape when soldering is being carried out. Aluminium is the preferred metal because it forms a protective oxide layer. The embossing pattern should-be such as to provide sufficient metal contact points at the outer surface of the adhesive layer to dissipate static. An embossing pattern as used for the known electromagnetic shielding tape is suitable. Each of the embossed protrusions may suitably be tapered with a rounded apex.

In this embodiment it is not necessary for the pressure sensitive adhesive layer to contain electrically conductive particles. The pressure-sensitive adhesive is preferably a polysiloxane adhesive. A primer layer e.g. of polysiloxane polymer may be applied to the plane metal foil before the pressure-sensitive polysiloxane adhesive is coated thereon, in order to improve the bonding of the pressure-sensitive adhesive to the foil. The primer layer does not reduce conductivity as the subsequent embossing of the metal foil causes the protrusions to penetrate the primer layer as well as the adhesive layer. The embossing is most suitably achieved by passing the metal foil coated with the pressure sensitive adhesive between a knurled roller and a resilient roller e.g. of rubber.

The adhesive-coated embossed foil may suitably be laminated to the polymeric film support by means of a heat-resistant laminating adhesive such as a polyacrylate, polysiloxane, epoxy or other adhesive type which forms a permanent bond which will not delaminate during the high temperature operation such as soldering. As the laminating adhesive forms a permanent bond, it is not necessary for the laminating adhesive to have such high properties of heat resistance as the pressure-sensitive adhesive which must be stripped away from the electronic component after use without leaving any residue.

As this embodiment provides conductive pathways of metal from the outer surface of the adhesive layer to and along the intermediate layer of metal, the bridging resistance measured with flat electrodes on the said outer surface is zero, the flat electrodes each being in contact with one or more of the protrusions of the intermediate layer.

### 1) Polymeric film support

The support can be any suitable polymeric film which has the requisite resistance to high temperature. It will normally be electrically insulative. The preferred material is polyimide film, particularly a polymer formed by the polycondensation reaction between an aromatic dianhydride and an aromatic diamine, more particularly of the kind commercially available from E.I. du Pont de Nemours & Co. under the Trade Mark "KAPTON", or a polyimide film available from Ube Industries, Japan under the Trade Mark UPILEX, or from Kanegafuchi Chemical Industries, Japan under the Trade Mark APICAL. Other suitable materials may be selected from polyvinyl alcohol film, aromatic polyamide paper, creped paper, polyether sulphone film (P.E.S.), polyetherimide film, polyphenylene sulphide film (P.P.S.), polyetherketone film (P.E.K.), polyetheretherketone film (P.E.E.K.) or polytetrafluoroethylene film.

Preferred film thickness is in the range 0.025-0.125mm.

### 2) Intermediate Conductive Layer

In the case of an intermediate layer formed of a layer of a polymeric binder containing electrically conductive filler particles, the minimum loading of filler must be sufficient to result in contact between adjacent filler particles, so that electrical conductivity is achieved along the layer. It is preferred to use a relatively high proportion of filler e.g. 20-90% by weight, preferably 30-80%, most preferably 35-70% by weight, based on the total solids of the intermediate layer.

The conductive filler can be any electrically conductive particles of suitable size. The particle shape may be spherical, irregular, fibrous or otherwise. It is preferred to use a small particle size relative to the thickness of the intermediate layer. The preferred average particle size is in the range 1-40 micrometres, more preferably 1-10 micrometres, most preferably 1-5 micrometres.

The most preferred fillers are graphite powder, and carbon black powder. Other preferred fillers are selected from metal powders such as nickel, aluminium, copper, bronze, silver or gold; or particles coated with any of the foregoing most preferred or preferred materials.

The binder for the conductive filler may be any suitable binder which meets the requirements of high-temperature resistance and compatibility with the support film and the adhesive layer. The most preferred materials are silicones and copolymers thereof such as silicone-polyester copolymers (having various ratios of silicone to polyester) or fluoro silicones. Other preferred binders include polyimides, epoxy resins, and poly(ethylene vinyl acetate). The preferred thickness of the coating is in the range 1-80 micrometres, most preferably 1-25 micrometres.

Instead of using a binder, one of the conductive materials may be applied to the support film, e.g. by laminating a metal foil to the support film or by embedding a powder into the surface of the film at high temperature.

In one embodiment, as discussed above, the metal foil is embossed to form protrusions through the adhesive layer. The metal is preferably aluminium.

### 3) Pressure-Sensitive Adhesive Layer

The pressure-sensitive adhesive is preferably a polysiloxane resin/gum adhesive in which the polysiloxane polymer (gum) is tackified by a lower molecular weight silicone resin. The preferred thickness of the adhesive layer is in the range 5-80 micrometres, most preferably 20-50 micrometres.

When the adhesive layer contains conductive particles, it is preferred to use a conductive filler having a relatively large particle size, more particularly an average particle size which is of the same order of magnitude as the thickness of the adhesive layer. The proportions of filler in the adhesive layer should be relatively low in order to avoid impairing the properties of cohesion, tack and adhesion. Loss of cohesion is particularly likely after treatment at high temperatures, especially if the filler is a metal which absorbs heat. The adhesive should also be chosen so that it does not leave a residue on the workpiece when it is stripped away.

It is preferred to use 1-60% by weight of filler, most preferably 5-30% by weight, based on the total solids of the adhesive layer.

The conductive filler can be any electrically conductive particles of suitable size. The particle shape may be spherical, irregular, fibrous or otherwise. The preferred average particle size is in the range 10-80 micrometres, most preferably 20-50 micrometres. The most preferred fillers are metal powders, particularly nickel, copper or aluminium. Other preferred materials include bronze powder, silver powder, gold powder, graphite powder, or carbon black powder; or particles coated with any of the foregoing most preferred or preferred materials.

The ratio between the average particle size of the filler and the thickness of the adhesive layer is preferably about 1:1 and may vary in the range 1:2 to 2:1.

In a preferred embodiment of the invention, the semi-conductive intermediate layer is coated onto the polymeric film support from a solution. The coated layer is dried to remove the solvent and cure the binder. Drying temperatures are suitably in the range 140-200°C for 2-10 minutes. Dry coating thicknesses of 0.001-0.025mm are suitable.

The self-adhesive layer may be coated from solution directly onto the semi-conductive layer and dried at 140-200°C for 2-10 minutes.

Suitable thicknesses for the self-adhesive layer range from 0.005mm-0.050mm. Once the adhesive has been applied, the tape may be wound up on itself into a roll. Shaped pieces of the tape may be prepared by die-cutting, after applying a release material to the adhesive side of the tape.

The intermediate layer and/or the adhesive layer may, if desired, contain other fillers and conventional additives.

The invention will be further described with reference to the drawings, in which:
Figure 1 is a diagrammatic enlarged cross section of one embodiment of a tape according to the invention;
Figure 2 is a graph of results of a conductivity test described in Example 2 below;
Figure 3 is a diagrammatic enlarged cross section of a second embodiment of a tape according to the invention.

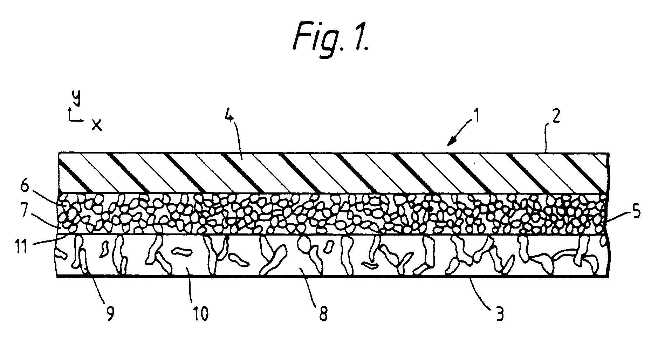

As shown in Figure 1, a tape 1 having two main planar surfaces 2, 3 comprises the following elements in sequence:
a polymeric film support 4;
an intermediate conductive layer 5 containing relatively small conductive filler particles 6 in a high-temperature resistant polymeric binder 7, the particles 6 being mutually in contact so as to provide conductive pathways along the intermediate layer i.e. in the x-z plane;
a pressure-sensitive adhesive layer 8 containing relatively large conductive filler particles 9 in a high-temperature resistant pressure-sensitive adhesive 10, the particles 9 either individually or in a combination of several particles providing conductive pathways in the y direction from the outer surface 3 of the adhesive layer to the inner surface 11 where the adhesive layer contacts the intermediate layer.

The x and y directions are indicated in Figure 1; the z direction is perpendicular to the Figure. The x-z plane is the main plane of the tape.

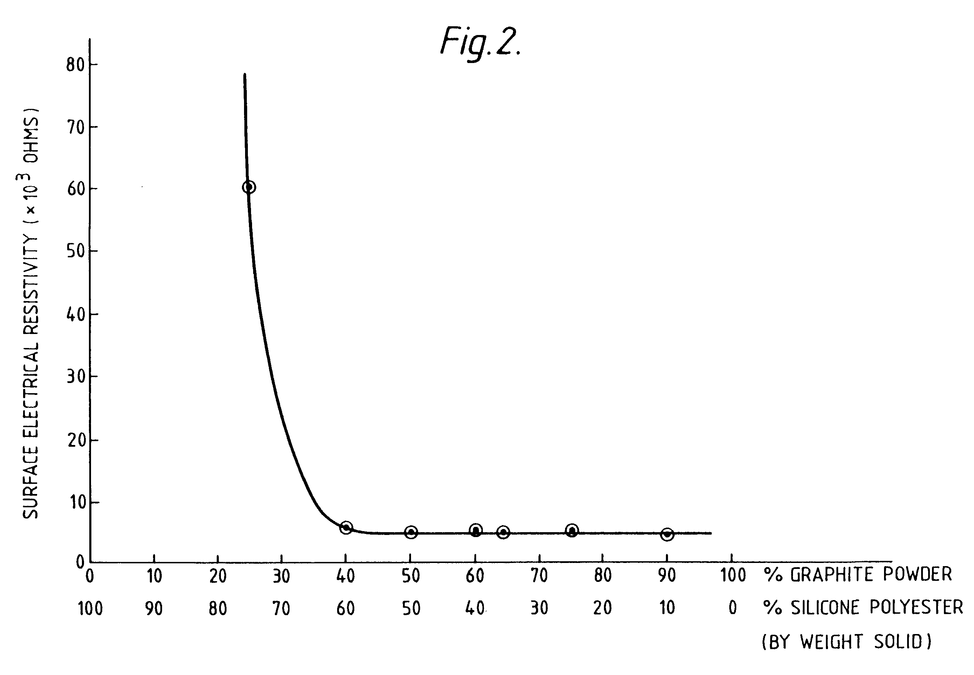

Figure 2 is described in Example 2 below.

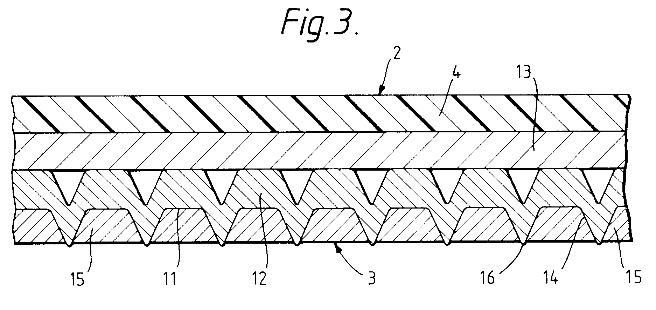

As shown in Figure 3, a second embodiment of a tape having main planar surfaces 2, 3 comprises the following elements in sequence:
a polymeric film support 4;
an intermediate conductive layer comprising embossed aluminium foil 12 laminated to the supporting film 4 by a layer of laminating adhesive 13; the foil 12 has been embossed to form a pattern of protrusions 14, each of which is of frustoconical shape, tapering to a rounded apex 16; the protrusions are arranged in lines, offset with respect to one another;
a pressure-sensitive adhesive layer 15, penetrated by the protrusions 14. The inner surface 11 of the adhesive layer abuts the main plane surface of the aluminium foil. The protrusions 14 project from the main plane of the aluminium foil and their points 16 lie in or slightly proud of the outer surface 3 of the adhesive layer 15. Thus the protrusions 14 provide conductive pathways from the outer surface of the adhesive layer to the intermediate layer.

Several embodiments of the invention are illustrated in the following Examples. The support film used in Examples 1-5 and 7 was polyimide film available under the Trade Mark KAPTON from E.I. du Point de Nemours & Co. Inc. while the support film used in Example 6 was polyether sulphone film (P.E.S), a film supplied by Imperial Chemical Industries (I.C.I.) Limited, Plastics Division, Herts, U.K. under the Trade Name STABAR. The silicone-polyester copolymer used in the intermediate layers in all Examples was a 30% silicone, 70% polyester copolymer supplied by Th. Goldschmidt AG, West Germany, under the Trade Mark SILIKOFTAL CC3. The polysiloxane resin/gum adhesive used in the pressure-sensitive adhesive layers in all Examples was supplied under the Trade Mark DC 280A by Dow Corning Corporation.

The average particle size quoted for the conductive particles is as stated by the suppliers. Particle size may be analysed by sieve analysis or by microtrack analysis in which light scattered by the particles determines shape and size.

### EXAMPLE 1

### A. Intermediate Conductive Layer

A solution was made up of the following:

| Ingredients | Parts by Weight |
|---|---|
| Silicone-polyester copolymer (60% by weight solution in butyl acetate) | 21 |
| Graphite powder (1-2 micrometre average particle size) | 25 |
| Ethyl acetate (66.5% filler/33.5% copolymer, based on total solids). | 54 |

When the solution was coated onto polyimide film of thickness 0.025mm, and dried for 5 minutes at 180°C to a thickness of 0.015mm, a grey opaque coating was obtained.

A piece of this coated film was examined for surface electrical conductivity using an ohm meter with the electrodes spaced at 1cm. The resistance range measured was 3000-5000 ohms/cm. In a comparative test using the same polyimide film but omitting the intermediate conductive layer, the resistance was measured at infinity on the same ohm meter.

### B. Conductive pressure-sensitive adhesive

A solution was made up as follows:

| | Parts by Weight |
|---|---|
| Polysiloxane resin/gum adhesive (55% by weight in toluene) | 43 |
| Benzoyl peroxide | 0.5 |
| Toluene | 53 |
| Aluminium powder (30-40 micrometres average particle size) | 3.5 |
| (12.9% filler/87.1% polysiloxane, based on total solids). | |

This solution was coated onto the intermediate conductive layer of A above and dried for 5 minutes at 180°C to a thickness of 0.03mm. A grey opaque tacky layer was formed. The coated film was rolled up and converted into rolls of 25mm width and 30 metre length. No release coating or interliner was required.

### Test procedure

1. The "Bridging" resistance of the adhesive surface was measured. This is the electrical resistance between two points on the adhesive surface, spaced 1cm apart. The path of electrical current is:
   (a) Through the adhesive in the y plane (i.e. perpendicular to the principal plane of the layer)
   (b) Along the intermediate conductive layer in the x-z plane (i.e. parallel to the principal plane of the layer)
   (c) Through the adhesive in the y plane
   1mm flat electrodes were used. The recorded resistance was in the range 50,000-70,000 ohms. In a comparative test using a standard tape of the same polyimide film and a similar pressure sensitive adhesive without the aluminium powder filler and omitting the intermediate conductive layer, the resistance was measured at infinity.
2. The static generation of the tape is measured using a static meter (No. 703 supplied by Minnesota Mining and Manufacturing Company) at a distance of 2 inches from the tape. During unwinding of the roll of tape at approximately 500mm/seconds, a reading of 0 volts was made. In a comparative test using a standard tape as described above, the reading was greater than 20,000 volts.
3. The tape (25mm x 150mm) was applied as masking tape to a selected area of a coated printed circuit board. The static reading during this process was 0 volts at 2 inches. For the standard tape, the reading was 3,000-4,000 volts.
4. The printed circuit board was processed through a wave soldering process which involved:
   (a) Preheating at 100-150°C
   (b) Dipping in organic flux
   (c) Passing through solder wave at 250°C (duration: 5 seconds)

After soldering the tape was inspected and was found to retain its physical properties and dimensions. There had been no lifting or delamination of the tape. None of the area which had been masked on the printed circuit board was exposed. The tape was then stripped from the printed circuit board. Zero static was recorded during removal. No traces of adhesive residue remained on the printed circuit board. In a comparative test using the standard tape as described above, the static reading during removal at 2 inches was 10-15,000 volts on the board and greater than 20,000 volts remaining on the piece of tape.

### EXAMPLE 2

### Intermediate Conductive Layer

The following solutions were produced:

| Composition No. | Parts by Weight | | | | | | | |
|---|---|---|---|---|---|---|---|---|
| | 1 | 2 | 3 | 4 | 5 | 6 | 7 | 8 |
| Silicone-polyester copolymer (60% by weight solution in butylacetate) | 170 | 150 | 100 | 100 | 70 | 45 | 10 | 7 |
| Graphite powder | 0 | 10 | 20 | 40 | 40 | 40 | 40 | 40 |
| Ethyl acetate | 200 | 200 | 200 | 200 | 200 | 150 | 150 | 150 |

Each of the solutions was coated onto polyimide film of thickness 0.025mm, and dried at 180°C for 5 minutes to a thickness of 0.015mm. A piece of each coated film was examined for surface electrical conductivity using an ohm meter with the electrodes spaced at 1cm. The results were reproduced on the accompanying graph (Figure 2) indicating the ratio of graphite powder to silicone-polyester copolymer in terms of weight percent solid/solid.

From the graph the optimum ratio to produce a flexible, cohesive coating with good electrical conductivity (3-5000 ohms) was found to be 40% graphite/60% silicone-polyester copolymer (solid/solid) which corresponds to Composition No. 4.

### EXAMPLE 3

### A. Intermediate Conductive Layer

The following solutions were produced:

| Composition No: | Parts by Weight | |
|---|---|---|
| | 3.1 | 3.2 |
| Silicone-polyester copolymer (60% by weight solution in butyl acetate) | 21 | 21 |
| Copper powder | 15 | |
| Nickel powder | | 15 |
| Ethyl acetate 54.3% filler/45.7% copolymer, based on total solids, in both formulations. | 54 | 54 |

Each of the solutions was coated onto polyimide film of thickness 0.025mm, and dried for 5 minutes at 180°C to a thickness of 0.015mm. Particle size of metal powders used was 0.010mm average.

Surface resistance measured as in Example 1 was recorded as

| | |
|---|---|
| Composition No. 3.1 | 5-10,000 ohms/cm |
| Composition No. 3.2 | 5-10,000 ohms/cm |

### B. Conductive Pressure-sensitive adhesive

As Example 1.

### Test procedure

As Example 1. There was no deformation, lifting or delamination of either tape sample during the wave soldering process.

### Results

| | | |
|---|---|---|
| 1. Bridging Resistance: | 3.1 | 50,000-70,000 ohms/cm |
| | 3.2 | 50,000-70,000 ohms/cm |
| 2. Unwind Static: | 3.1 | 0 Volts |
| | 3.2 | 0 Volts |
| 3. Application Static: | 3.1 | 0 Volts |
| | 3.2 | 0 Volts |
| 4. Removal: | 3.1 | 0 Volts, no adhesive residue. |
| | 3.2 | 0 Volts, no adhesive residue. |

### EXAMPLE 4

### A. Intermediate Conductive Layer

As Example 1.

### B. Conductive Pressure-sensitive adhesive

A solution was made up as follows:

| | Parts by Weight |
|---|---|
| Polysiloxane resin/gum adhesive (55% by weight in toluene) | 43 |
| Benzoyl peroxide | 0.5 |
| Toluene | 53 |
| Copper powder (30-40 micrometres average particle size) | 3.5 |

This solution was coated onto the intermediate conductive layer of A above (Example 1) and dried for 5 minutes at 180°C to a thickness of 0.03mm.

### Test Procedure

As Example 1. There was no deformation, lifting or delamination of the tape.

### Results

| | |
|---|---|
| 1. Bridging Resistance: | 50,000-65,000 ohms/cm. |
| 2. Unwind Static: | 0 Volts. |
| 3. Application Static: | 0 Volts. |
| 4. Removal: | 0 Volts. No adhesive residue. |

### EXAMPLE 5

A further example is illustrated which provides optimum adhesion of intermediate conductive layer to the polyimide film, and of the conductive pressure-sensitive adhesive to the intermediate conductive layer. The anti-static properties of the tape are maintained.

### A. Intermediate Conductive Layer

A solution was made up of the following:

| Ingredients | Parts by Weight |
|---|---|
| Silicone-polyester copolymer (60% by weight solution in butyl acetate) | 27 |
| Graphite powder (1-2 micrometre particle size) | 19 |
| Ethyl acetate (54% filler/46% copolymer, based on total solids). | 54 |

When the solution was coated onto polyimide film of thickness 0.025mm, and dried for 5 minutes at 180°C to a thickness of 0.015mm, a grey coating was obtained.

Surface resistance measured as in Example 1 was recorded as 3,000-5,000 ohms/cm.

### B. Conductive Pressure-Sensitive Adhesive

A solution was made up as follows:

| | Parts by Weight |
|---|---|
| Polysiloxane Resin/gum adhesive (55% by weight in toluene) | 44 |
| Benzoyl peroxide | 1.2 |
| Toluene | 50 |
| Nickel Powder (20-25 micrometre flakes, 1 micrometre thickness average particle size) | 4.8 |
| (16.5% filler/83.5% polysiloxane, based on total solids). | |

This solution was coated onto the intermediate conductive layer of A above (Example 5) and dried for 5 minutes at 180^{o}C to a thickness of 0.02mm.

### Test Procedure

As Example 1.

### Results

| | |
|---|---|
| 1. There was no deformation, lifting or delamination of either tape sample during the wave soldering process. | |
| 2. Bridging resistance: | 50,000-70,000 ohms/cm. |
| 3. Unwind Static: | 0 Volts. |
| 4. Application Static: | 0 Volts. |
| 5. Removal: | 0 Volts, no adhesive residue. |

### EXAMPLE 6

The polymeric film support used was polyether sulphone film (P.E.S.), a film supplied by Imperial Chemical Industries (I.C.I.) Limited, Plastics Division, Herts, U.K. under the Trade Name STABAR. The film thickness was 0.025mm.

### A. Intermediate Conductive Layer

As Example 5.

### B. Conductive pressure-sensitive adhesive

As Example 5.

### Test Procedure

As Example 1. There was no deformation, lifting or delamination of the tape.

### Results

| | |
|---|---|
| 1. Bridging Resistance: | 50,000-70,000 ohms/cm |
| 2. Unwind Static: | 0 Volts |
| 3. Application Static: | 0 Volts. |
| 4. Removal: | 0 Volts, no adhesive residue. |

### EXAMPLE 7

This example illustrates the use of an embossed metal foil as the intermediate layer which will also provide conductive pathways through the adhesive. The polymeric support was polyimide film of thickness 0.025mm.

### Laminating adhesive.

The laminating adhesive was a typical pressure-sensitive thermosetting polyacrylate type which will permanently bond the polyimide film to the embossed foil.

The adhesive was coated onto the polyimide film and cured for 3 minutes at 120°C to a thickness of 0.030mm.

### A. Intermediate layer and pressure sensitive adhesive.

The intermediate layer was an aluminium foil of thickness 0.040mm, initially unembossed.

### B. Pressure Sensitive Adhesive

A solution was made up as follows:

| | Parts by Weight |
|---|---|
| Polysiloxane resin/gum adhesive (55% by weight in toluene) | 43 |
| Benzoyl peroxide | 0.5 |
| Toluene | 56.5 |

The adhesive was coated onto the aluminium foil and cured at 180°C for 5 minutes to a dry thickness of 0.030mm. This adhesive-coated foil was then embossed by passing it through a knurled roller creating 48 points sq./cm of adhesive penetration by the protrusions of the embossed foil, as shown in Figure 3.

Finally the embossed aluminium tape was laminated to the adhesive coated polyimide film.

### Test Procedure

As Example 1.

### Results

| | |
|---|---|
| 1. There was no deformation, lifting or delamination of either tape sample during the wave soldering process. | |
| 2. Bridging resistance: | 0 ohms. |
| 3. Unwind static: | 0 volts. |
| 4. Application static: | 0 volts. |
| 5. Removal: | 0 volts, no adhesive residue. |

## Claims

1. An antistatic pressure-sensitive adhesive masking tape for use during a high temperature operation at temperatures up to 250°C and subsequent removal comprising
1) a polymeric film support (4);
2) an intermediate electrically-conductive layer (5, 12);
and
3) a layer of polysiloxane pressure-sensitive adhesive (8, 15);
wherein the polymeric film support, intermediate electrically conductive layer and polysiloxane pressure-sensitive adhesive layer are each resistant to temperatures up to 250°C for up to 5 seconds,
and wherein electrically conductive pathways (9, 14) are provided from the outer surface (3) of the pressure-sensitive adhesive layer (9, 14) to the intermediate layer (5).

2. A tape according to Claim 1 wherein the support, intermediate layer and pressure-sensitive adhesive layer are all resistant to temperatures up to 260°C for up to 25 seconds.

3. A tape according to either of the preceding claims wherein the intermediate layer (5) comprises a layer of a polymeric binder (7) containing electrically conductive particles (6) which provide conductive pathways in at least one direction parallel to the main plane of the tape, preferably such that the intermediate layer has a surface electrical resistance not greater than about 10⁵ ohms/cm.

4. A tape according to Claim 3 wherein the intermediate layer contains 30-80% by weight of conductive filler, based on the total solids of the intermediate layer, the filler preferably having an average particle size in the range 1-5 micrometres.

5. A tape according to any of the preceding claims wherein the intermediate layer comprises a layer of a polymeric binder selected from silicones and copolymers thereof such as silicone-polyester copolymers or fluorosilicones, polyimides, epoxy resins and poly(ethylene vinyl acetate) and an electrically conductive filler selected from graphite powder, carbon black powder, nickel, aluminium, copper, bronze, silver and gold powders, and particles coated with any of the foregoing.

6. A tape according to Claim 1 or 2 wherein the intermediate layer comprises a metal coating preferably of aluminium applied to the polymeric film support by metallisation or as a laminated metal foil.

7. A tape according to any of the preceding Claims wherein the pressure-sensitive adhesive layer (8) is in contact with the intermediate layer and the adhesive contains electrically conductive particles (9) which provide conductive pathways from one main face (3) of the adhesive layer to the other (11).

8. A tape according to Claim 7 wherein the pressure-sensitive adhesive layer contains 5-30% by weight of conductive filler (9), preferably having an average particle size in the range 20-50 micrometres.

9. A tape according to Claim 8 wherein the ratio between the average particle size of the filler in the adhesive layer and the thickness of the adhesive layer is in the range 1:2 to 2:1, preferably about 1:1.

10. A tape according to Claim 7 wherein the conductive filler is selected from metal powders including nickel, copper or aluminium, bronze powder, silver powder, gold powder, graphite powder or carbon black powder.

11. A tape according to any of Claims 1-6 wherein the intermediate electrically-conductive layer (12) has protrusions (14) which extend through the pressure-sensitive adhesive layer (15) and which provide the conductive pathways from the outer surface (3) of the adhesive layer to the intermediate layer.

12. A tape according to Claim 11 wherein the intermediate layer comprises a metal foil (12) which has been embossed to produce such protrusions.

13. A tape according to Claim 12 wherein the embossed metal foil coated with the pressure-sensitive adhesive is laminated to the polymeric film support by means of a heat-resistant laminating adhesive (13).

14. An antistatic pressure-sensitive adhesive tape comprising:
1) a polymeric film support (4);
2) an intermediate electrically conductive coating (5) on the support,
and
3) a layer of polysiloxane pressure-sensitive adhesive (8) in contact with the intermediate electrically-conductive coating (5), the adhesive containing electrically-conductive particles (9) which provide conductive pathways from one main face (3) of the adhesive layer to the other (11),
the polymeric film support, intermediate coating and adhesive layer all being resistant to temperatures up to 250°C for up to 5 seconds.

## Patentansprüche

1. Antistatisches druckempfindliches Maskierungs-Klebeband zur Verwendung während einer Hochtemperatur-Operation bei Temperaturen von bis zu 250°C und anschließender Entfernung, umfassend
1) einen polymeren Filmträger (4):
2) eine elektrisch leitfähige Zwischenschicht (5, 12); und
3) eine Schicht aus druckempfindlichem Polysiloxan-Klebstoff (8, 15);
in welchem der polymere Filmträger, die elektrisch leitfähige Zwischenschicht und die Schicht aus druckempfindlichem Polysiloxan-Klebstoff jeweils für bis zu 5 Sekunden gegen Temperaturen von bis zu 250°C beständig sind und in welchem elektrisch leitfähige Pfade (9, 14) von der äußeren Oberfläche (3) der druckempfindlichen Klebstoffschicht (9, 14) zur Zwischenschicht (5) vorgesehen sind.

2. Band nach Anspruch 1, in welchem der Träger, die Zwischenschicht und die druckempfindliche Klebstoffschicht alle für bis zu 25 Sekunden gegen Temperaturen von bis zu 260°C beständig sind.

3. Band nach irgendeinem der vorangehenden Ansprüche, in welchem die Zwischenschicht (5) eine Schicht aus einem polymeren Bindemittel (7) umfaßt, das elektrisch leitfähige Teilchen (6) enthält, die leitfähige Pfade in mindestens einer Richtung parallel zur Hauptebene des Bandes vorzugsweise derart bereitstellen, daß die Zwischenschicht einen elektrischen Oberflächenwiderstand von nicht höher als etwa 10⁵ Ohm/cm aufweist.

4. Band nach Anspruch 3, in welchem die Zwischenschicht 30 bis 80 Gewichts-% leitfähigen Füllstoff, bezogen auf den Gesamtfeststoff der Zwischenschicht, enthält, wobei der Füllstoff vorzugsweise eine durchschnittliche Teilchengröße im Bereich 1 - 5 Mikrometer aufweist.

5. Band nach irgendeinem der vorangehenden Ansprüche, in welchem die Zwischenschicht eine Schicht aus einem polymeren Bindemittel, ausgewählt aus Siliconen und Copolymeren davon, wie beispielsweise Silicon-Polyester-Copolymeren oder Fluorsiliconen, Polyimiden, Epoxy-Harzen und Poly(ethylenvinylacetat), und einem elektrisch leitfähigen Füllstoff, ausgewählt aus Graphitpulver, Rußpulver, Nickel-, Aluminium-, Kupfer-, Bronze-, Silber- und Goldpulvern und Teilchen, die mit irgendwelchen der Vorstehenden beschichtet sind, umfaßt.

6. Band nach Anspruch 1 oder 2, in welchem die Zwischenschicht einen Metallüberzug, vorzugsweise aus Aluminium, umfaßt, der auf dem polymeren Filmträger durch Metallisierung oder als laminierte Metallfolie aufgebracht wurde.

7. Band nach irgendeinem der vorangehenden Ansprüche, in welchem die druckempfindliche Klebstoffschicht (8) in Kontakt mit der Zwischenschicht steht, und der Klebstoff elektrisch leitfähige Teilchen (9) enthält, die leitfähige Pfade von einer Hauptseite (3) der Klebstoffschicht zur anderen (11) bereitstellen.

8. Band nach Anspruch 7, in welchem die druckempfindliche Klebstoffschicht 5 - 30 Gewichts-% leitfähigen Füllstoff (9), vorzugsweise mit einer durchschnittlichen Teilchengröße im Bereich 20 - 50 Mikrometer, enthält.

9. Band nach Anspruch 8, in welchem das Verhältnis zwischen der durchschnittlichen Teilchengröße des Füllstoffs in der Klebstoffschicht und der Dicke der Klebstoffschicht im Bereich von 1:2 bis 2:1, vorzugsweise bei etwa 1:1, liegt.

10. Band nach Anspruch 7, in welchem der leitfähige Füllstoff aus Metallpulvern, die Nickel, Kupfer oder Aluminium einschließen, Bronzepulver, Silberpulver, Goldpulver, Graphitpulver oder Rußpulver ausgewählt ist.

11. Band nach irgendeinem der Ansprüche 1 - 6, in welchem die elektrisch leitfähige Zwischenschicht (12) Vorsprünge (14) aufweist, die sich durch die druckempfindliche Klebstoffschicht (15) hindurch erstrecken und die die leitfähigen Pfade von der äußeren Oberfläche (3) der Klebstoffschicht zur Zwischenschicht bereitstellen.

12. Band nach Anspruch 11, in welchem die Zwischenschicht eine Metallfolie (12) umfaßt, die geprägt wurde, um derartige Vorsprünge zu erzeugen.

13. Band nach Anspruch 12, in welchem die mit dem druckempfindlichen Klebstoff beschichtete geprägte Metallfolie mit Hilfe eines wärmebeständigen Laminierklebstoffs (13) an den polymeren Filmträger laminiert ist.

14. Antistatisches druckempfindliches Klebeband, umfassend:
1) einen polymeren Filmträger (4);
2) einen elektrisch leitfähigen Zwischenüberzug (5) auf dem Träger;
und
3) eine Schicht von druckempfindlichem Polysiloxan-Klebstoff (8) in Kontakt mit dem elektrisch leitfähigen Zwischenüberzug (5), wobei der Klebstoff elektrisch leitfähige Teilchen (9) enthält, die leitfähige Pfade von einer Hauptseite (3) der Klebstoffschicht zur anderen (11) bereitstellen,
wobei der polymere Filmträger, der Zwischenüberzug und die Klebstoffschicht alle für bis zu 5 Sekunden gegen Temperaturen von bis zu 250°C beständig sind.

## Revendications

1. Ruban de masquage adhésif par contact, antistatique, pour une utilisation durant une opération à température élevée à des températures jusqu'à 250°C et retrait ultérieur comportant
1) un support en pellicule polymère (4) ;
2) une couche électriquement conductrice intermédiaire (5, 12) ; et
3) une couche d'adhésif par contact en polysiloxane (8, 15) ;
dans lequel le support en pellicule polymère, la couche électriquement conductrice intermédiaire et la couche d'adhésif par contact en polysiloxane résistent chacun jusqu'à 5 secondes à des températures jusqu'à 250°C ,
et dans lequel des trajets électriquement conducteurs (9, 14) sont prévus depuis la surface extérieure (3) de la couche d'adhésif par contact (9, 14) jusqu'à la couche intermédiaire (5).

2. Ruban selon la revendication (1), dans lequel le support, la couche intermédiaire et la couche d'adhésif par contact résistent tous jusqu'à 25 secondes à des températures jusqu'à 260°C.

3. Ruban selon l'une quelconque des revendications précédentes, dans lequel la couche intermédiaire (5) comporte une couche d'un liant polymère (7) contenant des particules électriquement conductrices (6) qui constituent des trajets conducteurs dans au moins une direction parallèle au plan principal du ruban, de préférence de telle sorte que la couche intermédiaire présente une résistance électrique superficielle non supérieure à environ 10⁵ Ohms/cm.

4. Ruban selon la revendication 3, dans lequel la couche intermédiaire contient de 30 à 80% en poids d'une charge conductrice, rapportés à la quantité totale de matières solides de la couche intermédiaire, la charge ayant de préférence une dimension de particule moyenne comprise entre 1 et 5 micromètres.

5. Ruban selon l'une quelconque des revendications précédentes, dans lequel la couche intermédiaire comporte une couche d'un liant polymère choisi parmi des silicones et des copolymères de ceux-ci tels que des copolymères silicone-polyester ou des fluorosilicones, polyimides, résines epoxy et poly(éthylène-acétate de vinyle) et une charge électriquement conductrice choisie parmi la poudre de graphite, la poudre de noir de carbone, des poudres de nickel, d'aluminium, de cuivre, de bronze, d'argent et d'or, et des particules revêtues de l'un quelconque des précédents.

6. Ruban selon la revendications 1 ou 2, dans lequel la couche intermédiaire comporte un revêtement métallique de préférence en aluminium appliqué au support en pellicule polymère par métallisation ou en tant que feuille métallique laminée.

7. Ruban selon l'une quelconque des revendications précédentes, dans lequel la couche d'adhésif par contact (8) se trouve en contact avec la couche intermédiaire et l'adhésif contient des particules électriquement conductrices (9) qui constituent des trajets conducteurs depuis une face principale (3) de la couche d'adhésif à l'autre (11).

8. Ruban selon la revendication 7, dans lequel la couche d'adhésif par contact contient de 5 à 30% en poids d'une charge conductrice (9), de préférence possédant une dimension de particule moyenne comprise entre 20 et 50 micromètres.

9. Ruban selon la revendication 8, dans lequel le rapport entre la dimension de particule moyenne de la charge dans la couche d'adhésif et l'épaisseur de la couche d'adhésif est compris entre 1:2 à 2:1, de préférence environ 1:1.

10. Ruban selon la revendication 7, dans lequel la charge conductrice est choisie parmi des poudres de métal comprenant le nickel, le cuivre ou l'aluminium, la poudre de bronze, la poudre d'argent, la poudre d'or, la poudre de graphite ou la poudre de noir de carbone.

11. Ruban selon l'une quelconque des revendications 1 à 6, dans lequel la couche électriquement conductrice intermédiaire (12) présente des parties saillantes (14) qui s'étendent à travers la couche d'adhésif par contact (15) et qui constituent les trajets conducteurs depuis la surface extérieure (3) de la couche d'adhésif jusqu'à la couche intermédiaire.

12. Ruban selon la revendication 11, dans lequel la couche intermédiaire comporte une feuille métallique (12) qui a été emboutie pour produire ces parties saillantes.

13. Ruban selon la revendication 12, dans lequel la feuille métallique emboutie revêtue de l'adhésif par contact est appliquée au support en pellicule polymère au moyen d'une colle résistant à la chaleur (13).

14. Ruban adhésif par contact, antistatique, comportant :
1) un support en pellicule polymère (4) ;
2) un revêtement intermédiaire électriquement conducteur (5) sur le support,
et
(3) une couche d'adhésif par contact au polysiloxane (8) en contact avec le revêtement intermédiaire électriquement conducteur (5), l'adhésif contenant des particules électriquement conductrices (9) qui constituent des trajets conducteurs entre une face principale (3) de la couche d'adhésif à l'autre (11),
le support en pellicule polymère, la couche de revêtement intermédiaire et la couche de colle résistant tous jusqu'à 5 secondes à des températures allant jusqu'à 250°C.
